# EUROPÄISCHE PATENTANMELDUNG

(11) **EP 0 823 726 A1**
(43) Veröffentlichungstag der Anmeldung: **11.02.1998**
(21) Anmeldenummer: 97111878.1
(22) Anmeldetag: 11.07.1997
(51) Int. Cl.: H01L 21/321, C23F 4/00, H01L 21/311, H01L 21/3205

(54) **Verfahren zum Plasma-unterstützten anisotropen Ätzen von Metallen, Metalloxiden und deren Gemische**

(30) Priorität: 05.08.1996 DE 19631622
(71) Anmelder: SIEMENS AKTIENGESELLSCHAFT, 80333 München (DE)
(72) Erfinder: Hintermaier, Frank, Dr., 81373 München (DE); Mazure-Espejo, Carlos, Dr., 85614 Kirchseeon (DE)

(57) **Zusammenfassung**

Aufgrund mangelnder Anisotropie bei der Gasphasenätzung von Metallen, Metalloxiden und deren Gemische können häufig nur schräge Ätzprofile erreicht werden, die häufig dem Ätzprofil einer rein physikalischen Ätzung entsprechen. Grund dafür ist, daß zumeist nichtflüchtige Metallverbindungen durch die Gasphasenätzung entstehen. Durch die Beimischung von Komplexbildnern, wie Kohlenmonoxid oder Phosphin bzw. Phosphinderivate, werden anstatt der schwerflüchtigen Metallsalze leichtflüchtige Metallkomplexe erzeugt, so daß die Anisotropie der Ätzung stark erhöht werden kann.

## Beschreibung

Die Erfindung betrifft ein Verfahren zum plasmaunterstützten anisotropen Ätzen von Metallen, Metalloxiden und deren Gemische mit einem Ätzgas oder einen Ätzgasmischung.

Bei der Entwicklung von hochintegrierten Speicherbausteinen, wie z.B. DRAM's bzw. FRAM'S müssen die elektrischen Eigenschaften der Bausteine bei der fortschreitenden Miniaturisierung beibehalten werden. Insbesondere bei DRAM's werden deswegen immer dünnere Schichten von dielektrischen Materialien bei gleichzeitiger dreidimensionaler Strukturierung verwendet. Um bei dieser Miniaturisierung die gewünschten elektrischen Eigenschaften der Bauelemente, insbesondere der Speicherkondensatoren zu erhalten, werden in letzter Zeit anstatt des herkömmlichen Siliziumoxids andere Metalloxide, insbesondere Paraelelektrika und Ferroelektrika, zwischen den Kondensatorelektroden einer Speicherzelle verwendet. Beispielsweise kommen Bariumstrontiumtitanat, Bleizirkontitanat (PZT, Pb(Zr,Ti)O₃) bzw. Lanthan-dotiertes Bleizirkoniumtitanat oder Strontiumbismuttantalat (SBT, SrBi₂Ta₂O₉) als Dielektrika in den Kondensatoren der Speicherzellen bei DRAM's bzw FRAM's zum Einsatz.

Dabei werden diese Metalloxide auf bereits vorhandenen Elektroden (Bodenelektroden) abgeschieden. Die Prozessierung erfolgt dabei unter hohen Temperaturen, so daß die gewöhnlichen Materialien, aus denen normalerweise die Kondensatorelektroden bestehen, so z.B. dotiertes Polysilizium, leicht oxidiert werden und ihre elektrischen leitenden Eigenschaften verlieren.

Wegen ihrer guten Oxidationsbeständigkeit und/oder der Ausbildung elektrisch leitfähiger Oxide gelten 4d und 5d Übergangsmetalle, insbesondere Platinmetalle (Ru, Rh, Pd, Os, Ir, Pt) und insbesondere Platin selbst, als aussichtsreiche Kandidaten für den Einsatz als Elektroden in den obengenannten ferroelektrischen Speicherzellen.

Um solche Metallelektroden bzw. Zonen in denen Metalle und Metalloxide der obengenannter Art und deren Gemische vorliegen zu strukturieren, müssen diese Metallelektroden bzw. Zonen geätzt werden.

Dies geschieht nach dem Stand der Technik in der Regel durch ein sogenanntes plasmaunterstütztes anisotropes Ätzverfahren. Dabei werden physikalisch-chemische Verfahren angewandt, bei denen Gasgemische aus Argon und einem oder mehrerer reaktiver Gase, wie z.B. Sauerstoff, Chlor, Brom, Chlorwasserstoff, Bromwasserstoff bzw. halogenierte Kohlenwasserstoffe verwendet werden. Diese Gasgemische werden in der Regel in einem elektromagnetischen Wechselfeld bei geringen Drücken ionisiert.

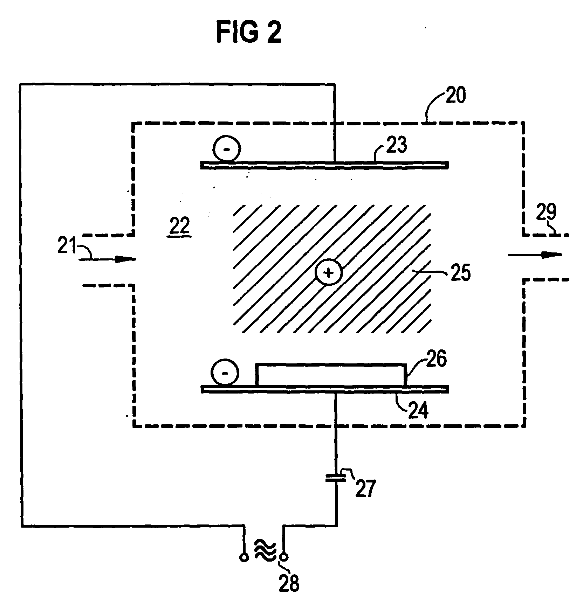

Fig. 2 zeigt die prinzipielle Arbeitsweise einer Ätzkammer, dargestellt am Beispiel eines Parallelplattenreaktors 20. Das Gasgemisch, z.B. Ar und Cl₂, wird über den Gaseinlass 21 der eigentlichen Reaktorkammer 22 zugeführt und durch den Gasauslass 29 wieder abgepumpt. Die untere Platte 24 des Parallelplattenreaktors ist über eine Kapazität 27 mit einer Hochfrequenzquelle 28 verbunden und dient als Substrathalter. Durch das Anlegen eines hochfrequenten elektrischen Wechselfeldes an die obere und die untere Platte 23, 24 des Parallelplattenreaktors wird das Gasgemisch in ein Plasma 25 überführt. Da die Beweglichkeit der Elektronen grösser als die der Gaskationen ist, laden sich obere und die untere Platte 23, 24 gegenüber dem Plasma 25 negativ auf. Daher üben beide Platten 23, 24 auf die positiv geladenen Gaskationen eine hohe Anziehungskraft aus, so daß sie einem permanenten Bombardement durch diese Ionen, z.B. Ar⁺ ausgesetzt sind. Da der Gasdruck zudem niedrig gehalten wird, nämlich 0.1 - 10 Pa, findet nur eine geringfügige Streuung der Ionen untereinander statt und die Ionen treffen nahezu senkrecht auf die Oberfläche eines Substrats 26, das auf der unteren Platte 24 des Parallelplattenreaktors gehalten ist. Dies erlaubt eine gute Abbildung einer Maske (nicht gezeigt) auf die darunterliegende, zu ätzende Schicht des Substrats 26.

Der physikalische Teil der Ätzung wird von dem eingebrachten Argon ausgeführt. Argonionen werden auf das zu ätzende Substrat gebracht und lockern in Folge ihrer hohen kinetischen Energie dort Substratatome, die wiederum mit den reaktiven Gasteilchen (Moleküle, Atome, Radikale) reagieren und dort chemische Verbindungen eingehen.

Im idealen Falle sollten diese chemischen Verbindungen flüchtig sein, d.h. sie sollten von der Substratoberfläche wegdiffundieren. Bei der Verwendung der obengenannten reaktiven Gase kommt es aber in der Regel zur Bildung von schwerflüchtigen Verbindungen und damit zu einer mangelnden Anisotropie der Gasphasenätzung. Ein weiterer Nachteil ergibt sich daraus, das abgetragenes Material aufgrund der zu geringen Flüchtigkeit unmittelbar neben der Ätzstelle wieder abgelagert wird. Insbesondere bei der Ätzung von Platin mit Chlorverbindungen entsteht schwerflüchtiges Platinchlorid (PtCl₂). Diese mangelhafte Flüchtigkeit liegt in der hohen Polarität der gebildeten Verbindungen, d.h. dem stark ionischen Charakter der Ätzprodukte, und der mangelhaften koordinativen Absättigung. Diese mangelhafte Absättigung der Ätzprodukte führt zur Aggregation der Ätzprodukte untereinander.

Ein Beispiel hierfür ist die Reaktivätzung von PZT (= Pb(Zr, Ti)O₃ ) in einem Ar Plasma mit CF₄ als reaktiver Komponente. Dabei werden u.a. die Produkte PbF₂, TiF₄ und ZrF₄ gebildet. Mit Ausnahme von TiF₄ sind diese Produkte jedoch aufgrund ihres salzartigen Charakters schwer flüchtig.

In analoger Weise ensteht bei der Ätzung von SBT (= SrBi₂Ta₂O₉) schwerflüchtiges SrF₂ und BiF₃. Auch bei Ätzung mit Cl₂/Ar werden schwerflüchtige Sr- und Bi-chloride gebildet.

Die Ätzung von Pt mit Cl₂/Ar bereitet ebenfalls Probleme, weil hierbei u.a. schwerflüchtiges PtCl₂ entsteht. PtCl₂ ist schwerflüchtig, weil die koordinative Absättigung einzelner PtCl₂-Einheiten dadurch stattfindet, daß diese Einheiten polymere Bänder [PtCl₂]ₙ ausbilden, bei denen ein Cl⁻-Ion zwei Pt²⁺ verknüpft.

Häufig kommt es durch die bisher eingesetzten Reaktionsgase aber auch zu einer unvollständigen Reaktion des abzutragenden Substrats. So wird z.B. bei der Ätzung von Pt auch die Ablagerung von elementarem Pt neben der zu ätzenden Stelle beobachtet. Die weist auf eine rein physikalische Ätzung hin bei der Pt-Dampf entsteht. Der Prozess ist analog zur Überführung von Pt von einem Target auf ein Substrat beim Sputtern

Aufgabe der vorliegenden Erfindung ist es daher, das eingangs genannte Verfahren zum plasmaunterstützten anisotropen Ätzen von Metallen, Metalloxiden und deren Gemische so weiterzubilden, daß die Bildung der schwerflüchtigen Ätzprodukte weitgehend vermieden wird.

Diese Aufgabe wird durch das Verfahren zum plasmaunterstützen anisotropen Ätzen von Metallen, Metalloxiden und deren Gemischen gemäß dem unabhängigen Patentanspruch 1 gelößt. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß wird die genannte Aufgabe dadurch gelöst, daß daß beim Ätzprozess ein Komplexbildner vorgesehen ist. Komplexbildner sind Stoffe, deren Moleküle mit Metallatomen koordinative Bindungen ausbilden, indem der Komplexbildner als Elektronendonator und das Metallatom als Elektronenakzeptor fungiert. Unter Metallatom sei hier nicht nur das elektrisch neutrale Metallatom gemeint, sondern auch Metallionen jedweder Wertigkeit.

Komplexbildner sind entweder einzähnig, d.h. sie besitzen nur eine Stelle am Molekül, die an das Metallatom koordinieren kann, oder mehrzähnig, d.h. mehrere Stellen des Komplexbildners können an ein Metallatom koordinieren.

Einzähnige Komplexbildner bilden nur dann stabile Addukte zu den Metallatomen, wenn sie starke Bindungen ausbilden können. Beispiele für solche hervorragenden einzähnigen Komplexbildner sind: CO, Phosphine PR₃ (z.B. PH₃, PF₃, P(OR)₃ (mit R= Alkylrest), Arsine AsR₃, Stibine SbR₃, Amine NR₃ (z.B. NH₃, NMe₃....), aber auch Anionen wie z.B. Cl⁻, Br⁻, I⁻, S²⁻, RS⁻.

Die oben erwähnten Anionen Cl⁻, Br⁻, I⁻, S²⁻, RS⁻ übernehmen jedoch meistens in erster Linie die Rolle der Ladungskompensation, z.B. in Salzen wie PtCl₂. In diesem Fall steht die Funktion des Ladungskompensators im Vordergrund und nicht die Komplexbildung. Die Funktion des Komplexbildners hingegen steht im Vordergrund, wenn sie eine Koordination an das Metallion eingehen ohne daß dies zum Ladungsausgleich erforderlich wäre, z.B. gilt dies für zwei der Chloridionen in PtCl₄²⁻.

Mehrzähnige Komplexbildner bilden häufig stabile Addukte zu den Metallatomen, weil sie gleich mehrfach an das Metallatom gebunden sind. Beispiele sind:
- 1.3-Diketonate (wie z.B. 2.2.6.6-Tetramethylhepta-3.5-dionat (thd), 1.1.1.5.5.5-Hexafluoropenta-3.5-dionat (hfac), und andere, teilweise unsymetrische 1.3-Diketonate)
- Di- und Polyamine, (z.B. N,N'-Tetramethylethylendiamin, N, N', N''-Pentamethyldiethylentriamin, etc.)
- Di- und Polyether (z.B. Diglyme, Triglyme, etc.).
- Carboxylate RCO₂⁻ (z.B. Pivaloat Me₃CCO₂⁻)

Als Komplexbildner haben sich insbesondere Kohlenmonoxid oder Phosphin oder Phosphinderivate als geeignet erwiesen.

So reagiert CO mit Pt in Gegenwart eines Ar/Cl Plasmas unter Bildung von gut flüchtigem (CO)₂PtCl₂. PF₃ bildet bildet mit durch Ar⁺ Beschuss aktiviertes Pt den flüchtigen Komplex Pt(PF₃)₄. Diese Komplexbildner können auch in einer plasmagestützten Reaktion aus geeigneten Vorstufen erzeugt werden, z.B. CO aus CO₂ oder aus COCl₂ (Phosgen).

Gemäß einer Ausführungsform der vorliegenden Erfindung kann jer Komplexbildner dem Ätzgas oder der Ätzgasmischung beigemischt werden.

In einer Weiterbildung der vorliegenden Erfindung kann der Komplexbildner auch in situ in der Ätzkammer aus anderen Gaskomponenten erzeugt werden. So kann z.B. in die Kammer eingebrachtes CO₂ oder COCl₂ durch die Plasmaentladung in den Komplexbildner CO überführt werden

Weiterhin ist es bevorzugt, wenn in der Ätzgasmischung ein Edelgas, insbesondere Argon, und/oder Distickstoff (N₂) verwendet wird.

Vorzugsweise wird als Ätzgasmischung ein Gasgemisch aus einer halogenhaltigen Verbindung oder Sauerstoff und Argon verwendet.

Vorzugsweise wird als Halogen entweder Chlor oder Brom und als halogenhaltige Verbindung organische Verbindungen, wie halogenierte Methane, Ethane oder Propane verwendet werden.

Gemäß einer weiteren Ausführungsform der vorliegenden Erfindung sind in der Ätzgasmischung Disauerstoff (O₂) und/oder Ozon (O₃) und/oder ein Stickoxid (N₂O, NO, NO₂) vorgesehen.

In einer Weiterbildung der vorliegenden Erfindung kann die Selektivität der Ätzung bzw. die Ätzrate genau eingestellt werden, indem die Gaspartialdrücke der einzelnen Gaskomponenten der Mischung aus Ätzgas bzw. Ätzgasmischung und Komplexbildner, die kinetische Energie der Argonatome sowie die Zusammensetzung der Gasmischung und die Ätztemperatur eingestellt werden.

Mit dem erfindungsgemäßen Verfahren können bevorzugt 4d oder 5d Übergangselemente und/oder deren Oxide zur Verwendung als Elektrodenmaterial geätzt werden.

Als Elektrodenmaterial werden dabei bevorzugt Edelmetalle (Pt, Pd, Rh, Ir, Ru, Os, Au), insbesondere das Edelmetall Pt, oder Edelmetalllegierungen und/oder deren Oxide oder Oxidgemische eingesetzt.

Dabei können die Elektroden einen beliebigen Aufbau besitzen, z.B. können sie eine Sandwichstruktur aus verschiedenen Komponenten, oder ein Gemisch aus Körnern verschiedener Materialien sein.

Weiterhin ist es bevorzugt, wenn das zur Ätzung verwendete Plasma im Niederdruckbereich (1-300 mtorr) betrieben wird.

Gemäß einer bevorzugten Weiterbildung der vorliegenden Erfindung wird das Plasma in einem Reaktor zum magnetisch verstärkten reaktiven Ionenätzen (MERIE), in Trioden-Reaktoren oder in Niederdruck-Hochionenstrom-Reaktoren (Helicon-Typ, TCP transformer coupled plasma, ICP inductively coupled plasma oder ECR electron cyclotron resonance Plasma) erzeugt.

Weiterhin ist es bevorzugt, wenn die zu ätzenden Stelle bestrahlt (z.B. mit Licht) oder einer Ultraschalleinwirkung ausgesetzt wird.

Mit dem erfindungsgemäßen Verfahren können auch Metalloxidschichten geätzt werden.

So ist es bevorzugt, daß ferroelektrisches Strontiumbismuttantalat (SBT, SrBi₂Ta₂O₉), Strontiumbismuthniobattantalat (SBNT, SrBi₂Ta₂₋ₓNbₓO₉, x=0-2) Bleizirkontitanat (PZT, Pb(Zr,Ti)O₃) oder Derivate sowie paraelektrisches Bariumstrontiumtitanat (BST, BaₓSr₁₋ₓTiO₃, x=0-1), Bleilanthantitanat (PLT, (Pb, La)TiO₃), Bleilanthanzirkontitanat (PLZT, (Pb, La)(Zr, Ti)O₃) oder Derivate derselbigen geätzt werden.

Die vorliegende Erfindung wird nun anhand der beiliegenden Zeichnungen näher erläutert. Es zeigen
Fig. 1 eine schematische Darstellung der zur Durchführung des erfindungsgemäßen Verfahren verwendeten Ätzkammer, und
Fig. 2 eine schematische Darstellung einer Ätzkammer in Form eines Parallelplattenreaktors,

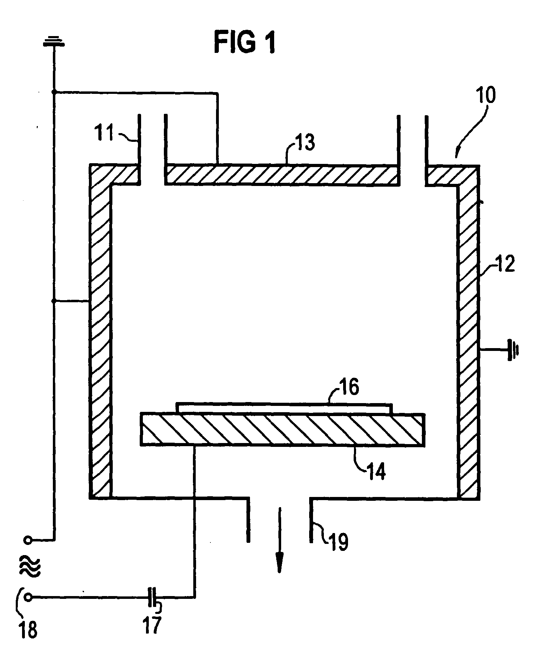

Die verwendete Ätzkammer 10 ist in Fig. 1 skizziert. Der Substrathalter 14 ist über eine Kapazität 17 mit einer Hochfrequenzquelle 18 verbunden und dient als die eine Elektrode. Als Gegenelektrode dienen Kammerwand 12 und Kammerdeckel 13, welche geerdet sind. Die eingespeiste HF-Leistung beträgt zwischen 100 und 1500 W. Das Gasgemisch wird durch den Gaseinlass 11 über dem Substrat 16 zugeführt und unter dem Substrat 16 durch den Gasauslass 19 wieder abgepumpt. Die Pumpe (nicht gezeigt) weist eine hohe Pumpleistung (350 l/min) auf, so daß hohe Durchflussgeschwindigkeiten erreicht werden können. Dadurch wird die Verweilzeit von gebildeten Reaktionsprodukten am Substrat 16 klein gehalten. Der Substrathalter 14 ist heizbar.

### Beispiele

a) Ätzung von Pt
   Gasgemisch: Ar, Cl₂, CO
   Gesamtdruck: 1-300 mTorr
   Ar-Fluss: 5-50 sccm
   Cl₂-Fluss: 5-50 sccm
   CO Fluss: 5-50 sccm
   Substrattemperatur: 0-100 C
   Substrat: 150 nm Pt auf SiO₂
   Ätzrate: 50-200 nm/min
b) Ätzung von Pt
   Gasgemisch: Ar, Cl₂, CO₂
   Gesamtdruck: 1-50 mTorr
   Ar-Fluss: 5-50 sccm
   Cl₂-Fluss: 5-50 sccm
   CO₂-Fluss: 5-50 sccm
   Substrattemperatur: 0-100 C
   Substrat: 150 nm Pt auf SiO₂
   Ätzrate: 50-200 nm/min
   c) Ätzung von SBT

Hierzu wird mit dem Ar Zufluss 1.1.1.5.5.5-Hexafluoropenta-3.5-dion (Hhfac) eingebracht. Dieses Dion das einen Siedepunkt von 70 C bei 760 torr besitzt, wird in einem Blubberer in die Gasphase überführt. Dazu wird Ar als Trägergas durch das flüssige Dion geleitet.
Gasgemisch: Ar, Dion
Gesamtdruck: 1-50 mTorr
Ar-Fluss: 5-50 sccm
Ar durch Blubberer: 5-50 sccm
Substrattemperatur: 100-300 C
Substrat: 100 nm SBT auf Pt
Ätzrate: 5-50 nm/min

In allen Beispielen konnte eine gute Anisotropie der Ätzung erreicht werden.

## Patentansprüche

1. Verfahren zum plasmaunterstützen anisotropen Ätzen von Metallen, Metalloxiden und deren Gemischen mit einem Ätzgas oder einer Ätzgasmischung,
**dadurch gekennzeichnet**,
daß beim Ätzprozess mindestens ein Komplexbildner vorgesehen ist.

2. Verfahren nach Anspruch 1,
**dadurch gekennzeichnet**,
daß der Komplexbildner dem Ätzgas oder der Ätzgasmischung beigemischt wird.

3. Verfahren nach Anspruch 1,
**dadurch gekennzeichnet**,
daß der Komplexbildner im Ätzgas oder der Ätzgasmischung in situ erzeugt wird.

4. Verfahren nach einen der Ansprüche 1 bis 3,
**dadurch gekennzeichnet**,
daß als Komplexbildner einzähnige Liganden verwendet werden.

5. Verfahren nach Anspruch 4,
**dadurch gekennzeichnet**,
daß als Komplexbildner Kohlenmonoxid oder Phosphin oder ein Phosphinderivat vorgesehen ist.

6. Verfahren nach einem der Ansprüche 1 bis 3,
**dadurch gekennzeichnet**,
daß als Komplexbildner mehrzähnige Liganden eingesetzt wird.

7. Verfahren nach Anspruch 6,
**dadurch gekennzeichnet**,
daß als Komplexbildner 1.3-Diketone oder Carbonsäuren oder Diamine oder Polyamine oder Diether oder Polyether oder deren Derivate eingesetzt werden.

8. Verfahren nach einem der Ansprüche 1 bis 7
**dadurch gekennzeichnet**,
daß in der Ätzgasmischung ein Edelgas und/oder Distickstoff (N₂) verwendet wird.

9. Verfahren nach Anspruch 8,
**dadurch gekennzeichnet**,
daß als Edelgas Ar eingesetzt wird.

10. Verfahren nach einem der Ansprüche 1 bis 9,
**dadurch gekennzeichnet**,
daß in der Ätzgasmischung ein Halogen oder eine halogenhaltige Verbindung vorgesehen sind.

11. Verfahren nach Anspruch 10,
**dadurch gekennzeichnet**,
daß als Halogen entweder Chlor oder Brom und als halogenhaltige Verbindung organische Verbindungen, insbesondere halogenierte Methane, Ethane oder Propane verwendet werden.

12. Verfahren nach einem der Ansprüche 1 bis 11,
**dadurch gekennzeichnet**,
daß in der Ätzgasmischung Disauerstoff (O₂) und/oder Ozon (O₃) und/oder ein Stickoxid (N₂O, NO, NO₂) vorgesehen sind.

13. Verfahren nach einem der Ansprüche 1 bis 12,
**dadurch gekennzeichnet**,
daß die Ätzrate und/oder die Selektivität durch zumindest einen der Parameter Druck, Zusammensetzung der Gasmischung, Ätztemperatur, Plasmaleistung oder kinetische Energie der Atome eingestellt werden.

14. Verfahren nach einem der Ansprüche 1 bis 13,
**dadurch gekennzeichnet**,
daß 4d oder 5d Übergangselemente und/oder deren Oxide zur Verwendung als Elektrodenmaterial geätzt werden.

15. Verfahren nach Anspruch 14,
**dadurch gekennzeichnet**,
daß als Elektrodenmaterial Edelmetalle (Pt, Pd, Rh, Ir, Ru, Os, Au) oder Edelmetalllegierungen und/oder deren Oxide oder Oxidgemische eingesetzt werden.

16. Verfahren nach Anspruch 15,
**dadurch gekennzeichnet**,
daß als Edelmetall Pt verwendet wird.

17. Verfahren nach Anspruch 14,
**dadurch gekennzeichnet**,
daß als Elektrodenmaterial Ru, Os oder Re-oxide oder deren Gemische verwendet werden.

18. Verfahren nach einem der Ansprüche 1 bis 17,
**dadurch gekennzeichnet**,
daß das zur Ätzung verwendete Plasma im Niederdruckbereich (1-300 mtorr) betrieben wird.

19. Verfahren nach einem der Ansprüche 1 bis 18,
**dadurch gekennzeichnet**,
daß das Plasma in einem Reaktor zum magnetisch verstärkten reaktiven Ionenätzen (MERIE), in Trioden-Reaktoren oder in Niederdruck-Hochionenstrom-Reaktoren erzeugt wird.

20. Verfahren nach einem der Ansprüche 1 bis 19,
**dadurch gekennzeichnet**,
daß die zu ätzenden Stelle bestrahlt oder einer Ultraschalleinwirkung ausgesetzt wird.

21. Verfahren nach einem der Ansprüche, 1 - 20,
**dadurch gekennzeichnet**,
daß eine Metalloxidschicht geätzt wird.

22. Verfahren nach Anspruch 21,
**dadurch gekennzeichnet**,
daß ferroelektrisches Strontiumbismuttantalat (SBT, SrBi₂Ta₂O₉) oder Strontiumbismuthniobattantalat (SBNT, SrBi₂Ta₂₋ₓNbₓO₉, x=0-2) oder Bleizirkontitanat (PZT, Pb(Zr,Ti)O₃) oder Derivate geätzt werden.

23. Verfahren nach Anspruch 22,
**dadurch gekennzeichnet**,
daß paraelektrisches Bariumstrontiumtitanat (BST, BaₓSr₁₋ₓTiO₃, x=0-1) oder Bleilanthantitanat (PLT, (Pb, La)TiO₃) oder Bleilanthanzirkontitanat (PLZT, (Pb, La)(Zr, Ti)O₃) oder Derivate derselbigen geätzt werden.
